# EUROPÄISCHE PATENTANMELDUNG

(11) **EP 3 668 295 A1**
(43) Veröffentlichungstag der Anmeldung: **17.06.2020**
(21) Anmeldenummer: 19214431.9
(22) Anmeldetag: 09.12.2019
(51) Int. Cl.: H05K 7/20, B60R 16/023

(54) **STEUERGERÄT ZUR AUSWERTUNG VON SIGNALEN FÜR EIN FAHRZEUG UND HERSTELLUNGSVERFAHREN FÜR EIN STEUERGERÄT ZUR AUSWERTUNG VON SIGNALEN FÜR EIN FAHRZEUG**

(30) Priorität: 11.12.2018 DE 102018221420
(71) Anmelder: ZF Friedrichshafen AG, 88046 Friedrichshafen (DE)
(72) Erfinder: Olpp, Maximilian, 88046 Friedrichshafen (DE); Grusser, Danny, 88069 Tettnang (DE); Heberle, Boris, 88045 Friedrichshafen (DE); Racoczi, Viktor, 88090 Immenstaad am Bodensee (DE)
(74) Vertreter: ZF Friedrichshafen AG

(57) **Zusammenfassung**

Es wird ein Steuergerät (SG) zur Auswertung von Signalen für ein Fahrzeug (FZ) vorgeschlagen mit wenigstens zwei mit zu kühlenden Bausteinen bestückten Leiterplatten (PB, CB), die sich gegenüberstehen und die an den gegenüberliegenden Seiten mit Kühlstrukturen (KS1, KS2) verdeckt sind. Weiterhin sind Seitenwände (SW) vorgesehen, die rechtwinklig zu den Kühlstrukturen (KS1, KS2) angeordnet sind und mit den Kühlstrukturen einen Kühlkanal bilden. Durch den Kühlkanal wird ein Fluid zum Wärmeabtransport bewegt. Es sind Dichtungsmittel zwischen den Seitenwänden und den Kühlstrukturen vorgesehen.

## Beschreibung

Die Erfindung geht aus von einem Steuergerät zur Auswertung von Signalen für ein Fahrzeug bzw. einem Herstellungsverfahren für ein Steuergerät zur Auswertung von Signalen für ein Fahrzeug nach der Gattung der unabhängigen Patentansprüche.

Aus DE 10 2017 002 601 A1 ist ein elektronisches Steuergerät für ein Kraftfahrzeug bekannt, bei dem ein Gaskühlkanal zum Führen eines verdichteten Gases vorgesehen ist. Dieser Gaskühlkanal ist mit einer ersten Steuerelektronik wärmeleitend verbunden und zum Trennen des verdichteten Gases von der ersten Steuerelektronik ausgebildet. Der Gaskühlkanal weist einen Entspannungsabschnitt auf, in dem sich ein Strömungsquerschnitt des Gaskühlkanals zum Entspannen und Abkühlen des verdichteten Gases zur Kühlung der ersten Steuerelektronik erweitert. Insbesondere ist es vorgesehen, dass der Gaskühlkanal zwischen zwei Leiterplatten vorgesehen ist, deren Bauelemente zueinander weisen.

Das erfindungsgemäße Steuergerät zur Auswertung von Signalen für ein Fahrzeug mit den Merkmalen des unabhängigen Patentanspruchs hat demgegenüber den Vorteil, dass die mit zu kühlenden Bausteinen bestückten Leiterplatten mit Kühlstrukturen jeweils verdeckt sind. Weiterhin sind noch Seitenwände vorgesehen, die rechtwinklig zu den Kühlstrukturen angeordnet sind und zusammen mit den Kühlstrukturen den Kühlkanal bilden. Damit ist ein gut umschlossener Kühlkanal realisiert. Weiterhin ist es vorgesehen, dass durch den Kühlkanal zum Wärmeabtransport ein Fluid bewegt wird. Damit wird im Unterschied zum Stand der Technik eine Strömungskühlung vorgeschlagen und keine Verdichtung eines Gases und anschließende Entspannung, was einen erheblichen Aufwand bedeuten würde. Hier kann das Fluid, also Luft oder eine Flüssigkeit, durch den Kühlkanal bewegt werden, beispielsweise im Falle von Luft durch die Umgebungsluft ansaugende Ventilatoren, um die Wärme, die durch die Bausteine auf den Leiterplatten erzeugt wird, über die jeweilige Kühlstruktur abzutransportieren. Schließlich sind auch Dichtungsmittel zwischen den Kühlstrukturen und den Seitenwänden vorgesehen. Damit durchströmt das Fluid einen hermetisch abgedichteten Kühlkanal.

Bei dem Steuergerät zur Auswertung von Signalen für ein Fahrzeug handelt es sich beispielsweise um ein Steuergerät, das verschiedenste Sensorsignale in einem Fahrzeug, beispielsweise einem Personenkraftwagen verarbeitet und daraus Steuersignale für eine Aktorik ableitet. Dafür kann das Steuergerät einen oder mehrere Prozessoren aufweisen, insbesondere Grafikprozessoren, aber auch Mikroprozessoren oder andere Recheneinheiten, um die Signale auszuwerten. Das Steuergerät kann insbesondere auch ein Gehäuse aufweisen, das aus Kunststoff, Metall oder einer Kombination daraus gebildet wird. Das heißt, das Steuergerät kann über verschiedenste Kommunikationskanäle Sensorsignale oder vorverarbeitete Sensorsignale bekommen, wertet diese mit seiner Rechenleistung aus und leitet daraus dann die Steuersignale ab. Damit sind also Signale entweder Rohdaten von Sensoren oder aber auch vorverarbeitete Sensorsignale, wo bereits Zwischenergebnisse erzielt wurden, oder auch eine Mischung daraus. Die Sensorsignale können über Punkt-zu-Punkt- oder Busverbindungen, aber auch optische Leitungen oder Funkverbindungen übertragen werden.

Bei den Leiterplatten handelt es sich um elektrische Leiterplatten, die Leiterbahnen aufweisen, um die Bausteine, die sich auf den Leiterplatten befinden, miteinander zu verbinden. Die Leiterplatten können insbesondere in einer Mehrschichttechnik ausgebildet sein. Vorzugsweise ist eine der zumindest zwei Leiterplatten die untere und die andere die obere. Gemäß einer bevorzugten Ausführung gibt eine untere Leiterplatte, die drei oberen Leiterplatten entgegensteht.

Die Bausteine, die elektronische Bausteine sind, wie Prozessoren, ASICs, Leistungsbausteine, geben Wärme im Betrieb ab. Daher sind diese Bausteine zu kühlen und die Wärme ist entsprechend abzutransportieren. Die Leiterplatten liegen sich vorliegend gegenüber im Steuergerät, das heißt, die Bausteine auf den beiden Leiterplatten weisen jeweils aufeinander zu. Jedoch sind diese Leiterplatten, die beispielsweise einen Abstand von 4 cm aufweisen, mit Kühlstrukturen verdeckt. Dieser Verdeckungsgrad kann vollständig sein, sodass eine komplette Struktur über der jeweiligen Leiterplatte befestigt ist. Beispielsweise können diese Kühlstrukturen auf den Leiterplatten jeweils lösbar befestigt sein, bspw. durch eine Schraubverbindung.

Die Kühlstrukturen sind gemäß der abhängigen Ansprüche und nachfolgenden Beschreibung näher definiert. Der Verdeckungsgrad durch die Kühlstrukturen kann wie gesagt vollständig sein, das heißt, die Leiterplatte ist vollständig durch die Kühlstruktur abgedeckt oder aber auch nur teilweise.

Unter Seitenwänden sind beispielsweise aus Aluminium gefertigte Strukturen zu verstehen, die zwischen den Kühlstrukturen rechtwinklig zu ihnen den Raum um die Leiterplatten und die Kühlstrukturen umgeben. Damit wird dann der Kanal gebildet. Diese Seitenwände können insbesondere einen Ventilator nach den Leiterplatten umfassen, der die Luft zum Abtransport der Wärme ansaugt oder bläst. Insbesondere sind diese Seitenwände nach zwei Seiten offen, sodass die Luft oder das Fluid den Kühlkanal durchströmen kann. Es ist möglich, dass die beiden Öffnungen des Kühlkanals auf einer Ebene liegen oder eine der Öffnungen in einem rechten Winkel zu der anderen Öffnung angeordnet ist. Durch den Kühlkanal wird also zum Wärmeabtransport ein Fluid bewegt. Neben Luft kann auch Wasser oder eine andere Flüssigkeit verwendet werden. Die Seitenwände können einstückig mit einer der Kühlstrukturen vorzugsweise ausgebildet sein. Insbesondere eignet sich die Kühlstruktur auf der unteren Leiterplatte für die einstückige Ausbildung mit den Seitenwänden.

Die Dichtungsmittel können durch den Zusammenbau realisiert sein oder danach durch eine Umspritzung. Beim Zusammenbau könnten insbesondere Gummidichtungen zum Einsatz kommen.

Das erfindungsgemäße Herstellungsverfahren für ein Steuergerät zur Auswertung von Signalen für ein Fahrzeug mit den Merkmalen des nebengeordneten Patentanspruchs beschreibt, wie solch ein Steuergerät hergestellt werden kann. Dabei wird die untere Leiterplatte auf den Gehäuseboden montiert. Danach erfolgt die Befestigung der unteren Kühlstruktur auf der unteren Leiterplatte. Sodann wird die untere Kühlstruktur mit einer oberen Kühlstruktur verbunden. Die obere Leiterplatte wird auf der oberen Kühlstruktur befestigt. Letztlich erfolgt die Montage des Gehäusedeckels auf der oberen Leiterplatte. Vorzugsweise erfolgt die Montage, die Befestigung und die Verbindung durch Schraubverbindungen. Es sind jedoch auch andere lösbare und nicht lösbare Verbindungen möglich. Insbesondere ist es möglich zwischen den Schritten bzw. davor und/oder danach weitere Fertigungsschritte vorzusehen.

Aus den in den abhängigen Ansprüchen aufgeführten Maßnahmen und Weiterbildungen sind vorteilhafte Verbesserungen des im unabhängigen Patentanspruch angegebenen Steuergeräts zur Auswertung von Signalen für ein Fahrzeug möglich.

Vorteilhaft ist, dass das Fluid gesaugt, geblasen oder gepumpt wird. Dabei ist insbesondere das Ansaugen oder das Blasen für Luft oder ein anderes Gas oder Gasgemisch vorteilhaft und das Pumpen für eine Flüssigkeit wie Wasser. Es kann jedoch auch ein Gas gepumpt werden.

Eine vorteilhafte Ausgestaltung ist, dass Umgebungsluft angesaugt wird und dabei durch den Kühlkanal bewegt wird. Damit ist es notwendig, den Kühlkanal eingangs- und ausgangsseitig mit der Umgebungsluft zu vebinden.

Weiterhin ist vorgesehen, dass die beiden Kühlstrukturen auf den gegenüberliegenden Seiten jeweils Strukturen zur Oberflächenvergrößerung und/oder zur Erzeugung von Turbulenzen aufweisen und auf den Leiterplatten zugewandten Seiten Entwärmungsstrukturen für einen Kontakt mit wenigstens einem Teil der zu entwärmenden Bauteile aufweisen. Damit sind die Kühlstrukturen derart definiert, dass sie im Kühlkanal solche Strukturen aufweisen, um damit mehr Fläche zu generieren und die Wärme besser abtransportieren zu können. Eine weitere Funktion dieser Strukturen ist, dass sie zu einer turbulenten Strömung führen, um eine Grenzschicht, die sich im Fluid um die Strukturen bildet, zu durchbrechen. Diese Grenzschicht hindert den effektiven Abtransport von Wärme.

Auf der der Leiterplatte zugewandten Seite sind die Entwärmungsstrukturen für einen Kontakt mit wenigstens einem Teil der zu entwärmenden Bauteile vorgesehen. Solche Entwärmungsstrukturen kontaktieren das Bauteil direkt, um die Wärme auf die Kühlstrukturen aufnehmen zu können, sodass die Wärme dann weiter zu den Strukturen fließen kann und dort abtransportiert werden kann. Es ist auch möglich, dass die Entwärmungsstrukturen die Bauteile indirekt kontaktieren, indem die Wärme von den Bauteilen durch die Leiterplatte zu einer Region fließt, die dann mit der Entwärmungsstruktur in Verbindung steht.

Diese Entwärmungsstrukturen können geometrisch so gefertigt sein, dass sie mit den Bauteilen in Berührung kommen oder nur ein Luftspalt zu den Bauteilen aufweisen und dann der Luftspalt bspw. durch ein sogenanntes thermisches Interface-Material, bspw. ein thermischer Gap-Filler gefüllt wird, das heißt der Luftspalt wird durch dieses Material ausgefüllt. Damit ist insbesondere auch eine kraftfreie Kontaktierung der Bauteile zum Wärmeabtransport möglich. Unter einem Gap-Filler ist in der Regel eine pastenartige Masse mit gesteigerter Wärmleitfähigkeit zu verstehen. Eine besonders hohe Steigerung der Wärmeleitfähigkeit kann durch die Beimischung von metallischen und oder keramische Partikel erfolgen.

Es ist vorgesehen, dass die Strukturen Rippen, PinFins und/oder Igelstrukturen sein können. Das sind Ausbildungen, die sich geeignet als solche Strukturen erwiesen haben.

Weiterhin ist es vorgesehen, dass die beiden Leiterplatten durch wenigstens eine elektrische Verbindung außerhalb der Seitenwände für eine Signal- und/oder Energieübertragung verbunden sind. Da zwischen den Leiterplatten nun der Kühlkanal vorgesehen ist, aber die beiden Platten auch in Verbindung stehen müssen, um Signale bzw. elektrische Energie gegenseitig übertragen zu können, ist außerhalb des Kühlkanals eine elektrische Verbindung vorzusehen. Diese elektrische Verbindung kann vorzugsweise eine weitere Leiterplatte sein, die rechtwinklig zu den anderen beiden Leiterplatten angeordnet ist, beispielsweise in einer Art Tasche neben den Seitenwänden, insbesondere einer Seitenwand des Kühlkanals.

Darüber hinaus ist es vorgesehen, dass auf einer ersten, unteren Leiterplatte drei Kühlkanäle jeweils durch drei weitere. obere Leiterplatten und deren Kühlstrukturen, die nebeneinander angeordnet sind, und zugehörige Seitenwände sowie drei weitere Kühlstrukturen auf der ersten Leiterplatte gebildet werden. Damit wird also eine Anordnung beschrieben, die nicht nur einen einzigen Kühlkanal hat, sondern drei, weil eine obere Leiterplatte, die auf der großen ersten, unteren Leiterplatte sitzt, dreimal vorhanden ist, um die Sensorsignale redundant verarbeiten zu können. Daher ist jeder Kühlkanal für jede der weiteren, oberen Leiterplatten voneinander getrennt. Eine solche Gesamtstruktur mit drei Kühlkanälen für drei Leiterplatten, die neben einander liegen, ist bezüglich der Signalauswertung besonders günstig, da dann eine ausreichende Redundanz für die Signalverarbeitung gegeben ist, wie sie beispielsweise bei automatisierten Fahrfunktionen notwendig ist.

Weiterhin ist vorgesehen, dass ein zu entwärmender Signalverarbeitungsbaustein auf der ersten, vorzugsweise unteren Leiterplatte unter einem Prozessor für die Verarbeitung der Signale auf der mittleren weiteren, vorzugsweise oberen Leiterplatte sich befindet. Bei der eben genannten Struktur mit drei Kühlkanälen ist es so, dass auf der unteren Leiterplatte ein Signalverarbeitungsbaustein ist, der Signale auf die Prozessoren auf den oberen drei Leiterplatten verteilt. Aus Signalintegritätsgründen ist es daher wichtig, den Abstand zu den Prozessoren auf den oberen Leiterplatten gleich zu gestalten, d.h. die Leitungen sind gleich lang. Dies vermeidet, dass die Prozessoren zu unterschiedlichen Zeiten die Signale verarbeiten. Insbesondere ist der Prozessor auf der mittleren Leiterplatte über dem Signalverarbeitungsbaustein auf der unteren Leiterplatte angeordnet. Damit sind optimale Bedingungen für die Signalverarbeitung gegeben. Der untere Signalverarbeitungsbaustein wird nämlich vorzugsweise wie oben angegeben die ankommenden Sensorsignale nach vorgegebenen Bedingungen auf die oberen Prozessoren verteilen.

Weiterhin ist es vorgesehen, dass die Rippen der gegenüberliegenden Kühlstrukturen nicht ineinandergreifen. Es liegt also keine Verzahnung vor. Damit ist ein guter Durchfluss für das Fluid gewährleistet.

Darüber hinaus ist es vorgesehen, dass die Rippen zumindest teilweise als Wellenrippen ausgebildet sind. Diese Wellenrippen sind besonders effizient für den Wärmeabtransport, weil sie die Fläche noch einmal erhöhen, die zur Verfügung steht, um sie mit dem Fluid umströmen zu lassen. Weiterhin induzieren die Wellenrippen mehr Turbulenz in die Strömung wie oben angegeben.

Weiterhin ist es vorgesehen, dass die Kühlstrukturen derart ausgebildet sind, dass die Kühlstrukturen wenigstens eine Entwärmungszone auf zumindest einer der beiden Leiterplatten zur Wärmeabfuhr kontaktieren. Es kann vorgesehen sein aufgrund beispielsweise der Größe der Bausteine auf einer Leiterplatte, dass diese Bausteine nicht direkt über die Kühlstruktur kontaktiert werden, sondern die Wärme wird über die Leiterplatte selbst zu sogenannten Entwärmungszonen auf der Leiterplatte transportiert. Dort kann dann eine Kontaktierung durch die Kühlstruktur erfolgen, um diese Wärme von der Leiterplatte letztlich abzutransportieren.

Weiterhin ist es vorgesehen, dass die Kühlstrukturen zumindest vorwiegend aus Aluminium bestehen. Aluminium ist ein leichter und wärmeleitfähiger Werkstoff, der günstig und leicht herzustellen ist.

Weiterhin ist es vorgesehen, dass bei der Kontaktierung der Kühlstruktur zu den Bausteinen oder auch zu den Entwärmungszonen ein thermisches Interface-Material vorgesehen ist, das die Kühlstruktur mit dem Baustein oder der Entwärmungszone thermisch koppelt. Vorzugsweise kann dafür ein thermischer Gap-Filler verwendet werden. Er ist wie oben angegeben eine Paste mit Silberpartikeln. Aber auch äquivalente Mittel zur Wärmekontaktierung zwischen Kühlstruktur und Entwärmungszone können dazu verwendet werden: Wärmeleitpasten, Wärmeleitkleber, Wärmeleitpads, Latentwärmespeicher.

Ausführungsbeispiele der Erfindung sind in der nachfolgenden Beschreibung näher erläutert und werden in der Zeichnung dargestellt.

Es zeigen
- Fig. 1: ein Blockschaltbild des erfindungsgemäßen Steuergeräts im Fahrzeug,
- Fig. 2: ein schematisches Schnittbild eines Kühlkanals,
- Fig. 3: eine Draufsicht auf eine Seitenwandstruktur mit Teil zur Aufnahme einer Leiterplatte,
- Fig. 4: eine schematische Darstellung der Querschnittsstruktur des Steuergeräts,
- Fig. 5: eine Querschnittsdarstellung der oberen Leiterplatte mit Kühlstruktur und angebundenen Bausteinen auf der Leiterplatte durch die Kühlstruktur,
- Fig. 6: eine Gesamtstruktur mit drei Kühlkanälen und
- Fig. 7: ein Verfahren des erfindungsgemäßen Herstellungsverfahrens.

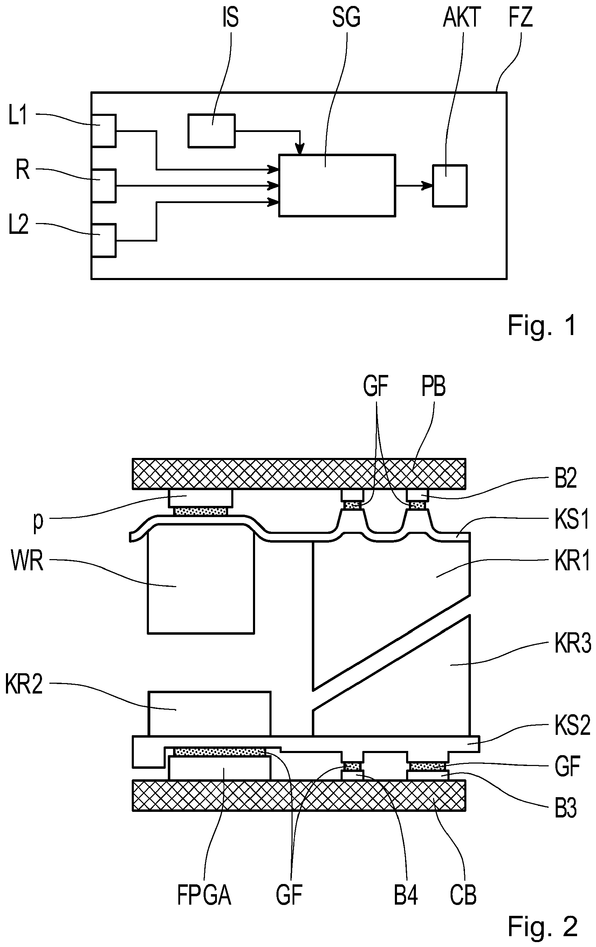

Fig. 1 zeigt in einem Blockschaltbild ein Fahrzeug FZ in schematischer Darstellung mit einem Steuergerät SG, an das verschiedene Sensoren Lidar L1 und L2, Radar R und eine Inertialsensorik IS angeschlossen sind. Es können noch weitere signalgebende Bausteine im Fahrzeug FZ an das Steuergerät SG angeschlossen sein. Das Steuergerät SG verarbeitet diese Signale und leitet daraus Steuersignale für eine Aktorik ab. Dazu kann beispielsweise das Steuergerät künstliche Intelligenz oder deterministische Algorithmen oder eine Kombination daraus verwenden.

Fig. 2 zeigt in einem Schnittbild einen erfindungsgemäßen Kühlkanal, der durch die Kühlstrukturen KS1 und KS2 gebildet wird und an den Seiten durch die nicht dargestellten Seitenwände. Unten befindet sich das sogenannte Carrier Board CB, das die Energie und Sensorsignale oder Signalaufnahme im Steuergerät SG bereitstellt. Dazu weist das Carrier Board CB einen sogenannten Baustein FPGA, also einen frei programmierbaren Gate Array auf, über den die Signale an die Prozessoren P auf dem Performance Board und weiteren Performance Boards verteilt werden, wenn es sich um mehrere Performance Boards handelt. Weitere Bausteine B4 und B3 sind beispielhaft auf dem Carrier Board CB dargestellt. Diese Bausteine, wie auch der FPGA, werden durch die Kühlstruktur KS2 kontaktiert.

Der Luftspalt, der zwischen der Kühlstruktur KS2 und den Bausteinen FPGA, B4 und B3 besteht, wird durch den sogenannten Gap-Filler GF aufgefüllt. Damit ist eine kraftfreie Verbindung hergestellt worden, da die Kühlstruktur KS2 auf diesen Luftspalt ausgerichtet wurde. Diese Ausrichtung kann beispielsweise durch Abstandshalter geschehen. Die Kühlstruktur KS2 weist auf der zum Kühlkanal hingewandten Seite die Kühlrippen KR2 und KR3 auf. Kühlrippen oder Rippen im Allgemeinen haben die Aufgabe, die Fläche zu erhöhen, die durch das Fluid umströmt wird, damit die Wärme noch effizienter abgeleitet werden kann. Das Performance Board PB ist oben angeordnet und weist seine Bausteine, zumindest die beispielhaft vorliegend dargestellten, nach unten in Richtung auf das Carrier Board CB.

Der Prozessor P, beispielsweise ein Grafikprozessor, und weitere Bausteine B1 und B2 sind auf dem Performance Board beispielhaft angeordnet. Wiederum ist die Kühlstruktur KS1 so ausgeführt, dass sie die Bausteine kontaktiert, wobei wiederum ein Gap-Filler GF jeweils in dem Luftspalt zwischen der Kühlstruktur KS1 und den Bausteinen enthalten ist. Auch hier wird vorzugsweise eine kraftfreie Kontaktierung verwendet. Die Kühlstruktur KS1 hat wiederum auch in den Kühlkanal gerichtet eine Wellenrippenstruktur WR, insbesondere unter dem Prozessor, der am meisten Energie umsetzt und damit am meisten Wärme erzeugen wird, und auch eine Kühlstruktur KR1, die Rippen in herkömmlicher Form aufweist, in Längsrichtung der Fluidströmung unter den Bausteinen B1 und B2.

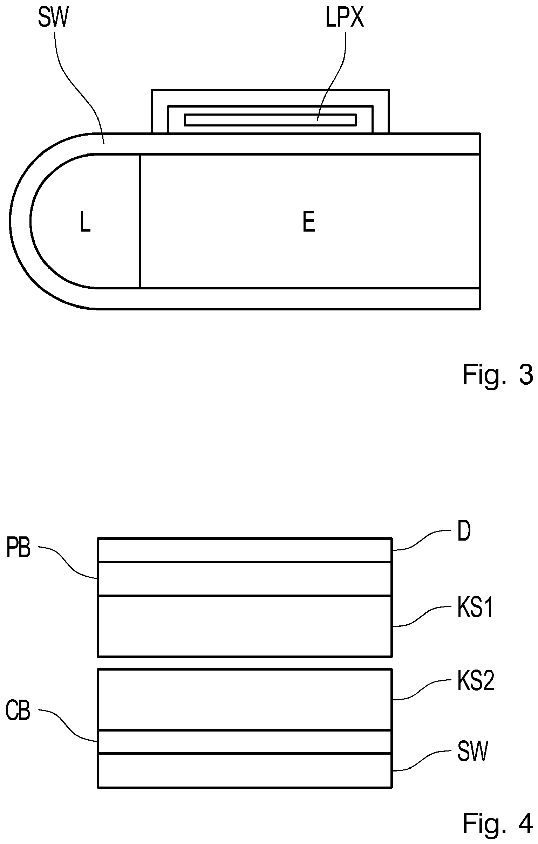

Fig. 3 zeigt eine Draufsicht auf die Struktur, die lediglich die Seitenwände zeigt. Diese Seitenwände definieren in horizontaler Richtung die Kühlkanäle. Die Seitenwände SW weisen einen Abschnitt L auf, in dem sich der Lüfter bei einer Luftkühlung üblicherweise befindet, der die Luft durch den Elektronikbereich E ansaugen wird. In dem Abschnitt E befindet sich die in Fig. 2 gezeigte Struktur. Die Seitenwände weisen eine Tasche auf, in der sich die Leiterplatte LPX befindet, die es ermöglicht, Signale und elektrische Energie vom Carrier Board CB an das Performance Board PB zu übertragen. Diese Leiterplatte LPX kann von unten entsprechend durch das Carrier Board CB kontaktiert werden, beispielsweise wie eine Steckkarte. Dabei werden dann die Seitenwände SW auf das Carrier Board CB aufgesetzt. Das Carrier Board CB könnte sich jedoch auch innerhalb der Seitenwandstruktur SW befinden.

Fig. 4 zeigt in einer schematischen Darstellung den Querschnitt des Elektronikabschnitts E des erfindungsgemäßen Steuergeräts. Wir haben einen Boden, der durch die Seitenwandstruktur SW gekennzeichnet ist, das Carrier Board CB, darauf folgend die Kühlstruktur KS2, danach folgend die Kühlstruktur KS1, durch die der Kühlkanal gebildet wird. Ein Luftspalt zwischen KS1 und KS2 ist je nachdem gegeben. Dieser kann auch unterschiedlich groß sein. Auf die Kühlstruktur KS1 folgt nach oben das Performance Board PB und darauf ein Deckel zum Schutz der Struktur.

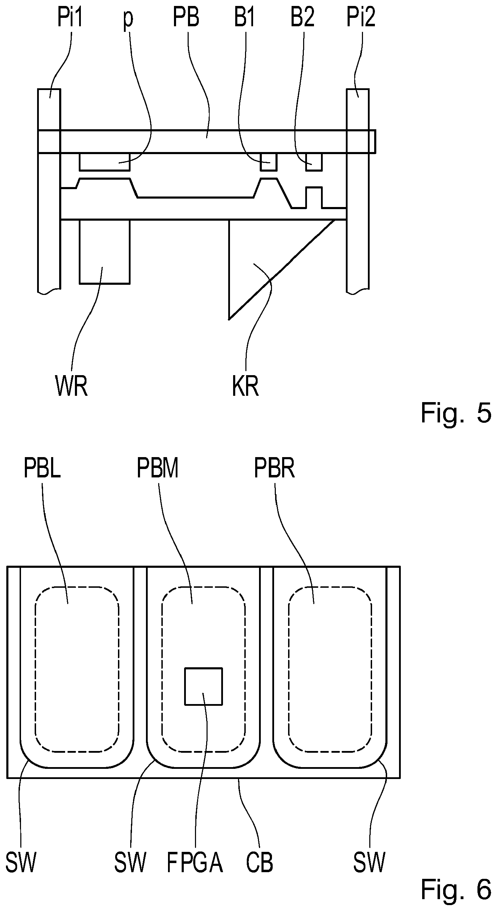

In der Fig. 5 wird eine Seitenansicht der Kühlstruktur KS1 mit dem Performance Board PB gezeigt. Das Performance Board PB und die Kühlstruktur KS1 sind auf zwei Säulen π1 und π2 montiert. Sie sind insbesondere so montiert, dass ein dünner Luftspalt zwischen der Kühlstruktur und seinen Strukturen hinsichtlich der Bauelemente B1 und B2 entsteht. Es ist also keine Kontaktierung gegeben von der Kühlstruktur zu diesen Bauelementen, die eine Kraft überträgt, um so die Zuverlässigkeit der Struktur zu gewährleisten. Würde eine Kraft übertragen werden, könnte dies die Bauelemente B1 und B2 negativ beeinflussen. Dieser Luftspalt zwischen den Bauelementen und der Kühlstruktur KS1 wird durch den Gap-Filler wie oben dargestellt dann geschlossen. Wiederum hat die Kühlstruktur KS1 unter dem Prozessor P die Wellenrippenstruktur WR und unter den Bauelementen B1 und B2 die Kühlrippenstruktur KR.

Fig. 6 zeigt eine Gesamtstruktur mit den drei Luftkanälen. Wir haben ein Carrier Board CB, auf dem über beispielsweise solche Säulen P1 und P2 jeweils drei Performance Boards PBL, PBM und PBR angeordnet sind. Der Signalverarbeitungsbaustein FPGA auf dem Carrier Board ist genau unterhalb des Prozessors P des mittleren Performance Boards PBM angeordnet. Dies ist aus signaltechnischen Gründen optimal. Die Seitenwandstrukturen SW umschließen die jeweiligen Strukturen, um die Kühlkanäle zu definieren. Die Lüfter sind der Einfachheit halber vorliegend weggelassen worden.

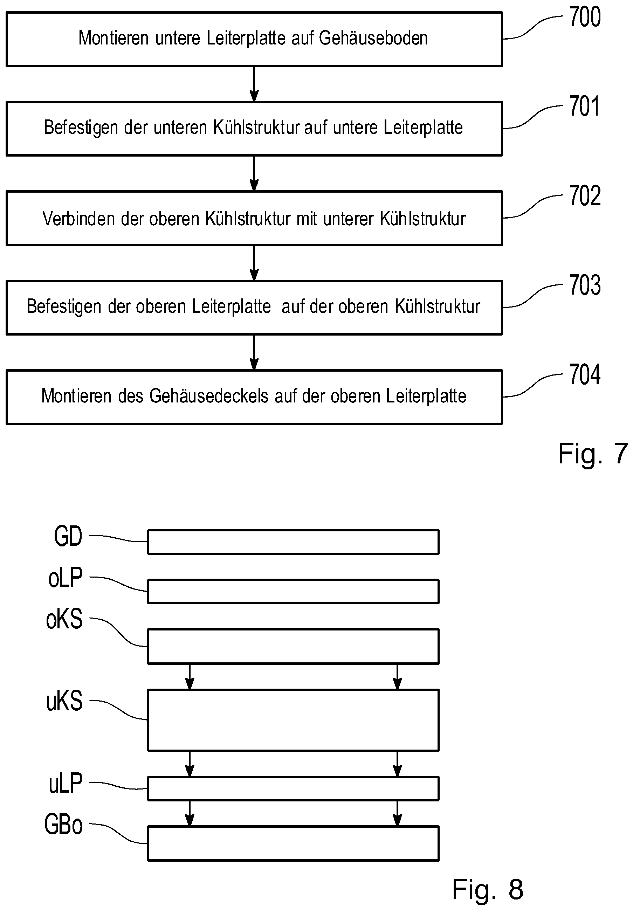

Fig. 7 zeigt in einem Flussdiagramm das erfindungsgemäße Herstellungsverfahren. In Verfahrensschritt 700 wird die obere Kühlstruktur mit der unteren Kühlstruktur verbunden. In Verfahrensschritt 701 wird die Leiterplatte an der unteren Kühlstruktur befestigt. In Verfahrensschritt 702 wird der Gehäuseboden an die untere Kühlstruktur montiert. In Verfahrensschritt 703 wird die obere Leiterplatte auf der oberen Kühlstruktur befestigt. In Verfahrensschritt 704 wird der Gehäusedeckel des Steuergeräts auf der oberen Leiterplatte befestigt.

Die Befestigung, Montage und Verbindung kann vorzugsweise durch Schraubverbindungen realisiert werden. Dabei weisen die einzelnen Elemente Gewinde auf, in die die jeweilige Schraube zur Herstellung der Verbindung, Befestigung oder Montage eingeschraubt werden kann. Die Gewinde können auch in Form von Buchsen ausgeführt sein. Optional können auch Selbstschneidende Schrauben verwendet werden.

Fig. 8 zeigt schematisch den Aufbau durch das erfindungsgemäße Herstellungsverfahren. Zunächst wird die obere Kühlstruktur oKS mit der unteren uKS verbunden. Die untere Kühlstruktur uKS kann die Seitenwände einstückig beinhalten. Weiterhin kann die untere Kühlstruktur uKS sowie der Gehäuseboden GBo und die untere Leiterplatte für eine Mehrzahl von Kühlkanälen konfiguriert sein. Dann wird die untere Leiterplatte auf der unteren Kühlstruktur uKS befestigt. Sodann wird der Gehäuseboden GBo auf die untere Kühlstruktur uKS geschraubt. In der oberen Kühlstruktur oKS wird die obere Leiterplatte oLP vorzugsweise verschraubt. Letztlich folgt der Abschluss durch den Gehäusedeckel der auf die obere Leiterplatte montiert wird.

### Bezugszeichen liste

- FZ: Fahrzeug
- L1,L2: Lidar
- R: Radar
- IS: Inertialsensorik
- SG: Steuergerät
- AKT: Aktorik
- PB: Performance Board
- GF: Gap-Filler
- P: Prozessor
- B1 - B4: Bausteine
- KS1, KS2: Kühlstrukturen
- CB: Carrier Board
- FPGA: Signalverarbeitungsbaustein
- WR: Wellenrippen
- KR1: Kühlrippen
- KR2: Kühlrippen
- KR3: Kühlrippen
- LPX: Leiterplatte
- SW: Seitenwände
- L: Lüfter
- E: Elektronik
- D: Deckel
- Pi1, Pi2: Säulen
- PBL, PBM, PBR: Performance Boards
- 700ff: Verfahrensschritte
- GBo: Gehäuseboden
- uLP: untere Leiterplatte
- uKS: untere Kühlstruktur
- oKS: obere Kühlstruktur
- oLP: obere Leiterplatte
- GD: Gehäusedeckel

## Patentansprüche

1. Steuergerät (SG) zur Auswertung von Signalen für ein Fahrzeug (FZ) mit:
- wenigstens zwei mit zu kühlenden Bausteinen bestückten Leiterplatten (PB, CB), die sich gegenüberstehen und die an den gegenüberliegenden Seiten mit Kühlstrukturen (KS1, KS2) verdeckt sind,
- Seitenwänden (SW), die rechtwinklig zu den Kühlstrukturen angeordnet sind und mit den Kühlstrukturen (KS1, KS2) einen Kühlkanal bilden, wobei durch den Kühlkanal zum Wärmeabtransport ein Fluid bewegt wird
- Dichtungsmitteln, die zwischen den Seitenwänden und den Kühlstrukturen vorgesehen sind.

2. Steuergerät nach Anspruch 1, **dadurch gekennzeichnet, dass** das Fluid gesaugt, geblasen oder gepumpt wird.

3. Steuergerät nach Anspruch 2, **dadurch gekennzeichnet, dass** als das Fluid Umgebungsluft angesaugt wird.

4. Steuergerät nach Anspruch 1, 2 oder 3, **dadurch gekennzeichnet, dass** die beiden Kühlstrukturen auf den gegenüberliegenden Seiten jeweils Strukturen zur Oberflächenvergrößerung und/oder zur Erzeugung von Turbulenzen (WR, KR) aufweisen und auf den den Leiterplatten zugewandten Seiten wenigstens eine Entwärmungsstruktur für einen Kontakt mit wenigstens einem Teil der zu entwärmenden Bauteile vorgesehen ist.

5. Steuergerät nach Anspruch 4, **dadurch gekennzeichnet, dass** die Strukturen Rippen, PinFins und/oder Igelstrukturen sind.

6. Steuergerät nach einem der Ansprüche 1 bis 5, **dadurch gekennzeichnet, dass** die beiden Leiterplatten (PB, CB) durch wenigstens eine elektrische Verbindung außerhalb der Seitenwände (SW) für eine Signal- und/oder Energieübertragung verbunden sind.

7. Steuergerät nach Anspruch 6, **dadurch gekennzeichnet, dass** die wenigstens eine elektrische Verbindung eine weitere Leiterplatte (LPX) ist.

8. Steuergerät nach einem der vorhergehenden Ansprüche, **dadurch gekennzeichnet, dass** auf einer der ersten, unteren Leiterplatte drei Kühlkanäle jeweils durch drei weitere, obere Leiterplatten und deren Kühlstrukturen, die nebeneinander angeordnet sind, und zugehörige Seitenwände sowie drei weiteren Kühlstrukturen auf der ersten Leiterplatte gebildet werden.

9. Steuergerät nach Anspruch 8, **dadurch gekennzeichnet, dass** wenigstens ein zu entwärmender Signalverarbeitungsbaustein (FPGA) auf der ersten Leiterplatte (CB) unter einem Prozessor (P) für die Verarbeitung der Signale auf der mittleren weiteren Leiterplatte (PBM) sich befindet.

10. Steuergerät nach einem der vorhergehenden Ansprüche 5-9, **dadurch gekennzeichnet, dass** die jeweiligen Rippen der gegenüberliegenden Kühlstrukturen nicht ineinandergreifen.

11. Steuergerät nach einem der vorhergehenden Ansprüche 5-10, **dadurch gekennzeichnet, dass** die Rippen zumindest teilweise als Wellenrippen (WR) ausgebildet sind.

12. Steuergerät nach einem der vorhergehenden Ansprüche, **dadurch gekennzeichnet, dass** die Kühlstrukturen derart ausgebildet sind, dass die Kühlstrukturen wenigstens eine Entwärmungszone auf zumindest einer der beiden Leiterplatten zur Wärmeabfuhr kontaktieren.

13. Steuergerät nach Anspruch 1, **dadurch gekennzeichnet, dass** die Kühlstrukturen zumindest vorwiegend aus Aluminium bestehen.

14. Steuergerät nach einem der Ansprüche 3 bis 11, **dadurch gekennzeichnet, dass** die Kühlstrukturen mit der wenigstens einen Entwärmungsstruktur für den Kontakt mit wenigstens einem Teil der zu entwärmenden Bauteile durch ein thermisches Interface-Material zwischen der wenigstens einen Entwärmungsstruktur und dem Bauteil verbunden sind, wobei das thermische Interface-Material die thermische Kopplung zwischen dem jeweiligen Bauteil und der Entwärmungsstruktur herstellt.

15. Herstellungsverfahren für ein Steuergerät nach einem der Ansprüche 1 bis 14 mit folgenden Schritten:
- Verbinden der oberen Kühlstruktur mit der unteren Kühlstruktur
- Montieren der unteren Leiterplatte (CB) auf der unteren Kühlstruktur
- Befestigen des Gehäusebodens (GB) auf der unteren Kühlstruktur
- Befestigen der oberen Leiterplatte (PB) auf der oberen Kühlstruktur
- Montieren eines Gehäusedeckels auf der oberen Leiterplatte.
